# DEMANDE DE BREVET EUROPEEN

(11) **EP 0 726 667 A1**
(43) Date de publication de la demande: **14.08.1996**
(21) Numéro de dépôt: 96400256.2
(22) Date de dépôt: 07.02.1996
(51) Int. Cl.: H04L 25/02, H03K 19/003

(54) **Coupleur d'entrée sortie de circuit intégré**

(30) Priorité: 08.02.1995 FR 9501457
(71) Demandeur: BULL S.A., 78430 Louveciennes (FR)
(72) Inventeur: Boudry, Jean-Marie, F-78180 Montigny le Bretonneux (FR)

(57) **Abrégé**

L'invention se situe dans le domaine des coupleurs d'entrées-sorties à commutation rapide pour bus de transfert de données à haut débit. Le coupleur d'entrée sortie d'un circuit intégré permet d'échanger des signaux avec des coupleurs identiques situés dans d'autres circuits intégrés au moyen d'une ligne de bus (51). Un tel coupleur comprend un émetteur (6) et un récepteur (7) raccordés à la ligne (51) par un conducteur (5). L'émetteur (6) comprend un interrupteur (63) dont l'état passant met le conducteur (5) à un potentiel Vb. Le coupleur comprend de plus un interrupteur (64) ou (65) dont l'état passant amène le conducteur (5) à un potentiel Vtt et tel que la mise à l'état passant de cet interrupteur n'est possible qu'après mise à l'état bloquant de l'interrupteur (63). Ainsi, la mise en conduction rapide de l'interrupteur (64) ou (65), permet d'obtenir des variations rapides entre deux états discrets de potentiel Vb et Vtt du conducteur électrique reliant l'émetteur à la ligne de bus, avec une grande stabilité sur chacun de ces deux états.

## Description

L'invention se situe dans le domaine des coupleurs d'entrées-sorties à commutation rapide pour bus de transfert de données à haut débit. Les fréquences de travail de ce type de coupleurs se situent dans une plage de 100 à 200 MHz. Il est possible d'utiliser la technologie CMOS pour privilégier les faibles dissipations thermiques. D'autre part, ce type de coupleurs est compatible avec la technologie ECL grâce à la définition d'une tension de travail de 0.8V.

Plusieurs coupleurs de ce type sont connectés sur une ligne de transmission commune, plusieurs lignes de transmission en parallèle constituent alors un Bus de transfert de données. Pour éviter les problèmes de réflexions en extrémité de ligne, lors de l'émission d'un signal par l'un des coupleurs, une résistance d'adaptation est montée à chacune des extrémités de la ligne. Cependant, un autre phénomène perturbateur vient entraver la rapidité de transfert. Les connexions du circuit émetteur sur les lignes du bus possèdent une inductance intrinsèque qui provoque des régimes transitoires oscillants à chaque commutation du signal à transmettre. Pour éviter une mauvaise interprétation du signal, Il est alors nécessaire d'attendre un amortissement suffisant de ces oscillations avant de générer une commutation suivante .

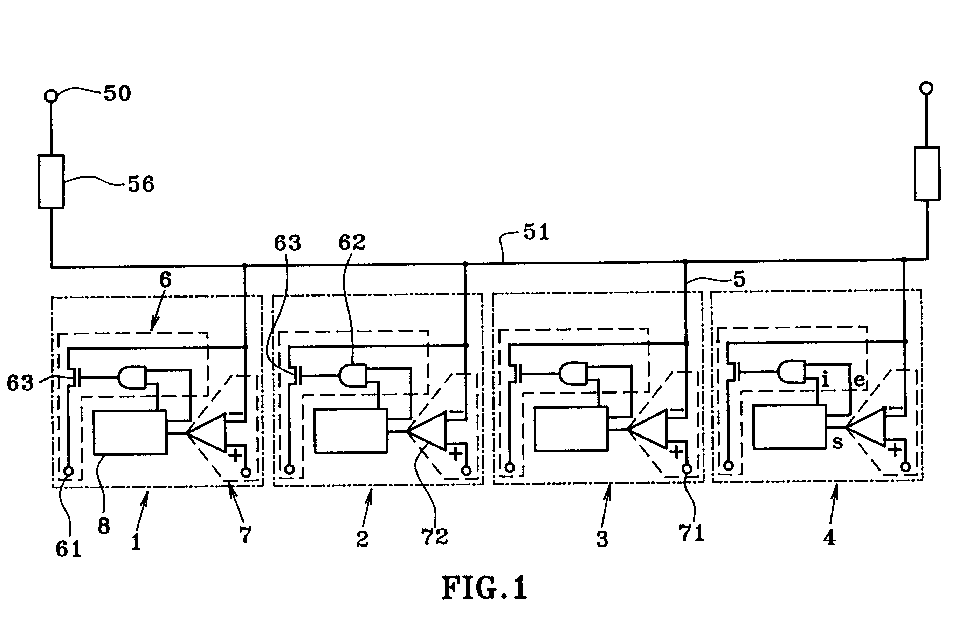

La figure 1 représente un système de l'état de la technique dans lequel plusieurs circuits intégrés 1, 2, 3, 4 communiquent entre eux par l'intermédiaire d'un bus de données. Un tel système ne se limite pas aux seuls quatre circuits intégrés représentés et offre un intérêt dès que deux circuits intégrés ont besoin de communiquer. Le bus de données comprend au moins une ligne 51 reliant les différents circuits intégrés destinés à communiquer entre eux. Pour échanger simultanément n signaux entre les différents circuits intégrés, le bus de données comprend alors n lignes 51 identiques, chacune d'elles étant attribuée à un signal. Pour chaque signal échangé avec l'ensemble des autres circuits intégrés, un circuit intégré possède un coupleur d'entrée-sortie relié à la ligne 51, attribuée à ce signal, par un conducteur 5. Le coupleur comprend un émetteur 6 dont la sortie est reliée au conducteur 5 et un récepteur 7 dont l'entrée est reliée à ce même conducteur 5. Le signal transmis est un signal binaire à deux états E1 et E0, à chacun desquels correspond une valeur de potentiel de la ligne 51. Les variations du potentiel entre ces deux valeurs s'effectuent à hautes fréquences. A ces fréquences, l'inductance et la capacitance intrinsèques de la ligne font que les variations de potentiel s'y propagent sous forme d'une onde. La vitesse de propagation de cette onde sur chaque tronçon de ligne est fonction de l'inductance et de la capacitance de ce tronçon qui en définissent alors une impédance caractéristique . Toute variation d'impédance provoque une variation de la vitesse de propagation de l'onde qui se décompose alors en une onde transmise et une onde réfléchie. Pour éviter ce phénomène, la ligne possède, tant que faire se peut, une structure et donc une impédance caractéristique Z constante sur toute sa longueur. Le branchement d'un coupleur sur la ligne provoque une discontinuité. Cependant, on considère habituellement que la structure de la ligne reste constante sur toute sa longueur en y répartissant uniformément les coupleurs à intervalles fixes. Il suffit alors de considérer comme tronçon élémentaire un tronçon de ligne de longueur égale à un intervalle. L'introduction d'un coupleur s'apparente essentiellement à l'introduction d'une capacité suplémentaire dans la ligne, ayant pour effet de réduire l'impédance caractéristique Z et d'augmenter légèrement le temps de propagation. En bout de ligne, est connectée l'une des extrémités d'une impédance 56, son autre extrémité étant raccordée à une source de potentiel fixe Vtt donnée par un noeud 50. La valeur de l'impédance 56 étant égale à l'impédance caractéristique de la ligne, on évite ainsi les phénomènes d'écho provoqués par une réflexion en bout de ligne. Il en résulte qu'en l'absence de signaux transmis, la ligne 51 est uniformément référencée au potentiel du noeud 50 par l'intermédiaire de l'impédance 56.

L'émetteur 6 comprend un interrupteur 63 connecté entre le conducteur 5 et une source de potentiel Vn donnée par un noeud 61. Cet interrupteur est commandé par un circuit 62. Ce circuit reçoit essentiellement deux signaux e et i d'une unité logique 8, située dans le même circuit intégré que l'émetteur 6. Par exemple, le 1 logique du signal e représente une autorisation d'émission de l'émetteur 6 et le 1 logique du signal i représente l'état E1 du signal à transmettre. La conjonction des signaux e et i rend passant l'interrupteur 63. A un instant donné, l'autorisation d'émission est réservée à un seul circuit intégré et aucun autre circuit intégré ne peut émettre sur la ligne 51.

Dans le circuit intégré recevant l'autorisation d'émission, lorsque le signal i est à zéro, représentatif de l'état E0 du signal à transmettre, l'interrupteur 63 est bloquant. La valeur du potentiel du conducteur 5 est égale au potentiel Vtt du noeud 50. Le passage à 1 du signal i, représentatif de l'état E1 du signal à transmettre rend passant l'interrupteur 63. L'interrupteur 63 possède, à l'état passant, une impédance propre R3. Ainsi, l'état passant de l'interrupteur 63 provoque dans le conducteur 5, l'apparition d'un courant I qui le place à une valeur de potentiel Vb dont la différence avec le potentiel Vn est égale au produit de l'impédance R3 par le courant I. L'impédance propre de l'interrupteur 63 étant généralement faible devant l'impédance caractéristique Z de la ligne, le potentiel Vb est proche du potentiel Vn du noeud 61. Le potentiel Vb du conducteur 5 se propage alors sur la ligne 51, à destination des coupleurs des autres circuits intégrés raccordés sur la même ligne 51. Puis, le passage à 0 du signal i, représentatif de l'état E0 du signal à transmettre rend bloquant l'interrupteur 63. La caractéristique connue d'un interrupteur est que dans son état bloquant, son impédance propre possède une partie résistive infinie et une partie réactive légèrement capacitive . Ainsi, l'état bloquant de l'interrupteur 63 s'oppose à la circulation du courant I dans le conducteur 5 et l'amène à une valeur de potentiel supérieure à Vb pour annuler le courant I. L'accroissement de potentiel du conducteur 5 se propage alors sur la ligne 51, à destination des coupleurs des autres circuits intégrés raccordés sur la même ligne 51.

Chaque coupleur comprend un récepteur 7 constitué essentiellement d'un amplificateur différentiel 72. L'entrée négative de l'amplificateur différentiel 72 est raccordée au conducteur 5 et l'entrée positive est raccordée à une source de potentiel Vref donnée par un noeud 71. La sortie de l'amplificateur différentiel 72 émet un signal s vers l'unité logique 8 du circuit intégré auquel appartient le coupleur. La valeur du potentiel Vref est comprise entre les valeurs Vb et Vtt. Par exemple, si Vtt=1,2V, Vb=0,4V, il est possible de prendre Vref=0,8V. Ainsi, si le potentiel du conducteur 5 est proche de Vtt, sa valeur supérieure au potentiel Vref amène l'amplificateur différentiel 72 en saturation négative générant un signal s au zéro logique. Si le potentiel du conducteur 5 est proche de Vb, sa valeur inférieur au potentiel Vref amène l'amplificateur 72 en saturation positive générant un signal s au 1 logique.

Chaque récepteur 7 transmet donc à l'unité logique 8 du circuit intégré auquel il appartient, un signal s à 1 lorsque le potentiel du conducteur 5 le raccordant à la ligne 51 est à Vb, c'est à dire lorsque l'état E1 d'un signal est transmis sur cette ligne. Par exemple, le récepteur 7 transmet à l'unité logique 8 du circuit intégré auquel il appartient, un signal s à 0 lorsque le potentiel du conducteur 5 le raccordant à la ligne 51 est à Vtt, c'est à dire lorsque l'état E0 d'un signal est transmis sur cette ligne ou en l'absence de signal transmis qui se confond avec l'état E0.

Comme nous l'avons vu précédemment, l'impédance 56, de valeur égale à l'impédance caractéristique de ligne, placée en bout de ligne, permet d'éviter les phénomènes d'écho. A la suite d'un changement d'état du signal transmis, il n'est donc pas nécessaire d'attendre l'amortissement de l'écho sur la ligne pour évaluer le nouvel état. L'évaluation du nouvel état effectuée permet alors de transmettre un nouveau changement d'état si besoin est. L'absence d'onde réfléchie en extrémité de ligne est prometteuse quant à la vitesse d'échange de signaux entre les différents coupleurs. On peut imaginer par exemple de ne pas attendre que l'onde de tension, liée au changement d'état, aie atteint l'extrémité de la ligne pour transmettre à sa suite une onde de tension liée à un nouveau changement d'état du signal. En disposant d'interrupteurs suffisamment rapides, il pourrait même être envisagé des fréquences de variation des signaux tels que la ligne 51 ne soit pas nécessairement équipotentielle mais possède simplement un potentiel déterminé au point d'évaluation du signal.

Cependant, on a remarqué que l'onde de tension qui se propage sur la ligne 51 à partir du coupleur émetteur du signal, n'est pas constituée d'un échelon parfait qui serait produit de façon idéale par l'ouverture ou la fermeture de l'interrupteur 63. On observe des ondes oscillantes qui viennent se superposer à l'onde en échelon parfait, représentative du signal à transmettre. Ces ondes oscillantes, de nature transitoire, sont amorties par l'impédance d'adaptation en extrémité de ligne. Toutefois, il arrive fréquemment que l'amplitude de ces ondes franchisse les seuils haut et bas de détection des récepteurs 7 connectés à la ligne. Il est alors nécessaire d'attendre un amortissement suffisant des oscillations pour effectuer une évaluation correcte du signal. Il est parfois possible que ce temps d'attente soit d'ordre comparable, voire supérieur au temps nécessaire aux ondes de tension pour atteindre l'extrémité de la ligne. Cette observation fait perdre les espoirs de rapidité promis par l'annulation de l'écho en extrémité de ligne.

Le problème posé, pour augmenter la vitesse de transfert de signaux entre différents circuits intégrés, est de réduire jusqu'à pratiquement éliminer les oscillations parasites. Or on attribue l'inconvénient précédemment cité aux contraintes inhérentes à la commutation de l'interrupteur 63 de l'émetteur. En effet le conducteur 5 de chaque coupleur ne peut être matériellement parfait. La connexion physique du coupleur, intégré dans le circuit dont il transmet les signaux, à la ligne 51 extérieure au circuit, impose au conducteur 5 une inductance qui, si faible soit-elle, n'en fait pas moins sentir sa présence sur les variations de courant véhiculées. D'autre part, l'amplificateur 72 du récepteur 7 possède une capacité d'entrée qui, liée au conducteur 5, constitue alors un circuit oscillant.

Une solution serait d'éliminer à la source les perturbations provoquées par le circuit oscillant mentionné ci-dessus en rendant le conducteur 5 ou l'interrupteur 63 suffisamment résistif pour créer un coefficient d'amortissement. Cette solution n'est pas satisfaisante car elle réduirait la bande passante du coupleur et induirait un effet Joule provoquant un échauffement du circuit. De plus, la nature oscillante du conducteur 5 ne se limite pas au seul coupleur qui émet mais impose encore sa présence dans chaque coupleur qui réceptionne le signal. Or, si le conducteur 5 était résistif, il provoquerait, par sa connexion sur la ligne 51, une rupture d'impédance de la ligne induite par le partage de l'onde courant-tension entre le conducteur 5 et l'aval de la ligne. D'autre part, le conducteur 5 d'un coupleur en réception se comporte comme une capacité en série avec une inductance et constitue donc un circuit oscillant. Une modification de l'onde de tension dans le conducteur 5 du récepteur risque d'être renvoyée sur la ligne, y provoquant ainsi des parasites.

Une autre solution serait de disposer, au niveau du conducteur 5 du coupleur récepteur, une impédance d'adaptation à la ligne 51 pour éviter toute retransmission d'onde sur la ligne par le récepteur. Cependant, la présence d'une résistance d'adaptation en un point autre que l'extrémité de la ligne présente un inconvénient pour l'onde représentative du signal. En effet, la résistance d'adaptation réduit la transmission de l'onde au delà du point où elle se situe sur la ligne. Il devient alors problématique de disposer un récepteur au delà du premier récepteur sans atténuation de l'onde transmise. C'est pourquoi cette solution est réalisée, selon l'état de la technique, sous forme de liaison dite série où seulement deux coupleurs émetteur-récepteur échangent leurs signaux sur une ligne, chaque coupleur étant disposé à une extrémité de la ligne. Pour faire communiquer un circuit intégré avec plusieurs autres circuits intégrés, il est alors nécessaire de prévoir plusieurs lignes de transmission avec pour chacune d'elles un coupleur dédié à cette ligne. Ceci présente entre autre l'inconvénient de multiplier le nombre de liaisons entre circuits intégrés et de devoir définir les circuits intégrés susceptibles de communiquer entre eux dès la conception du circuit électrique global dans lequel ces circuits viennent s'incorporer. De savantes architectures permettent d'optimiser le nombre de liaisons mais avilissent le système physiquement réalisé à sa conception originelle. Malgré toute la puissance du logiciel, il n'est pas possible de faire évoluer un tel système pour faire communiquer directement deux circuits intégrés, en créant ultérieurement des liaisons non matérialisées à l'origine.

L'objet de l'invention est de réaliser un coupleur apte à être connecté en grand nombre sur une même ligne de transmission à débit élevé. Un signal est transmis à débit élevé par la succession de variations rapides entre deux états discrets de potentiel Vb et Vtt de la ligne. Une interprétation correcte du signal nécessite une grande stabilité de chacun de ces deux états.

La solution de l'invention est un coupleur d'entrée sortie d'un circuit intégré, pour échanger des signaux avec au moins deux coupleurs identiques d'autres circuits intégrés par une ligne de bus, comprenant un émetteur et un récepteur raccordés à la ligne par un conducteur électrique, l'émetteur comprenant un premier interrupteur dont l'état passant, faiblement impédant, met le conducteur à un potentiel Vb, caractérisé en ce qu'il comprend au moins un deuxième interrupteur dont l'état passant amène le conducteur à un potentiel Vtt et tel que la mise à l'état passant du deuxième interrupteur n'est possible qu'après mise à l'état bloquant du premier interrupteur.

Ainsi, l'état bloquant du premier interrupteur, avant mise à l'état passant du deuxième interrupteur évite une mise à un potentiel intermédiaire du conducteur électrique par mise à l'état passant simultanée des deux interrupteurs, et assure la mise à deux états distincts de potentiel Vb et Vtt du conducteur électrique.

Le passage de l'état de potentiel Vb à Vtt est d'autant plus rapide que le laps de temps, séparant la mise à l'état passant du deuxième interrupteur après mise à l'état bloquant du premier interrupteur, est court.

Pour cela, l'invention propose comme deuxième interrupteur un interrupteur mis immédiatement à l'état passant par le franchissement de potentiel du conducteur électrique, d'un seuil au delà du potentiel Vtt . Dans son état passant, une conductivité électrique du deuxième interrupteur croissant avec le potentiel du conducteur électrique procure un avantage suplémentaire.

Ainsi, la mise en conduction rapide du deuxième interrupteur, à un niveau de conduction élevé, avec comme seule condition restrictive que le premier interrupteur soit bloquant, permet d'obtenir la combinaison de deux résultats à priori difficilement conciliables, un premier résultat de variations rapides possibles entre deux états discrets de potentiel Vb et Vtt du conducteur électrique reliant l'émetteur à la ligne de bus, un second résultat de grande stabilité sur chacun de ces deux états.

L'invention propose encore comme deuxième interrupteur dont la mise à l'état passant se fait avec une temporisation infinitésimale sur la mise à l'état bloquant du premier interrupteur.

Ici encore, la mise en conduction rapide du deuxième interrupteur, avec comme seule condition restrictive que le premier interrupteur soit bloquant, permet d'obtenir la combinaison de deux résultats à priori difficilement conciliables, un premier résultat de variations rapides possibles entre deux états discrets de potentiel Vb et Vtt du conducteur électrique reliant l'émetteur à la ligne de bus, un second résultat de grande stabilité sur chacun de ces deux états.

Lorsqu'un bus de données est constitué de plusieurs lignes en parallèle, chaque circuit intégré connecté à ce bus comprend un coupleur d'entrée-sortie pour chaque ligne. A chaque extrémité de chaque ligne est une impédance d'adaptation sous forme de composant extérieur aux circuits intégrés. Ces impédances d'adaptation encombrent de façon gênante le circuit imprimé sur lequel sont implantés les circuits intégrés.

Une application suplémentaire de l'invention permet d'éviter de connecter les impédances d'adaptation sous forme de composants extérieurs aux circuits intégrés. Pour cela le coupleur d'entrée sortie comprend un interrupteur impédant, connecté entre le premier conducteur électrique et le deuxième conducteur électrique au potentiel Vtt, dont l'impédance est égale à l'impédance caractéristique de la ligne, cet interrupteur étant passant lorsque le coupleur est situé à l'une des extrémités de la ligne, hors mode émission.

Ces réalisations ainsi que d'autres aspects et avantages de l'invention apparaîtront dans la suite de la description en référence aux figures.
- La figure 1 représente le schéma de principe d'un circuit électrique situant le contexte auquel s'applique l'invention.
- La figure 2 montre une représentation conceptuelle d'un circuit à haut débit d'échange d'information.
- La figure 3 met en évidence les premiers éléments distinctifs de l'invention.
- La figure 4 met en évidence des éléments distinctifs supplémentaires de l'invention.

Comme nous l'avons vu précédemment, la figure 1 présente un circuit électrique ne bénéficiant pas des avantages de l'invention. Supposons par exemple que le coupleur du circuit 2 soit en mode émission et que les coupleurs des autres circuits 1,3,4, à titre non limitatif, soient hors mode émission. La ligne 51 possède deux états stables de potentiel. Le premier état correspond à l'absence de circulation de courant dans la ligne qui la place au potentiel Vtt du noeud 50. Le second état correspond à la circulation d'un courant établi par le coupleur 2 qui la place au potentiel Vb proche du potentiel du noeud 61. Pour chaque état stable de la ligne 51, le conducteur 5 d'un quelconque coupleur est au même potentiel que la ligne 51. La ligne 51 étant initialement dans le premier état, les capacités d'entrée des amplificateurs 72 de chaque coupleur sont chargées au potentiel Vtt. La fermeture de l'interrupteur 63 du coupleur du circuit 2 provoque la circulation d'un courant dans le conducteur 5 de ce coupleur qui décharge la capacité d'entrée de l'amplificateur 72 et abaisse le potentiel du point de raccordement du conducteur 5 à la ligne 51 vers la valeur Vn donnée par le noeud 61. Cet abaissement de potentiel crée un front descendant qui se propage, sous forme d'une onde courant-tension en échelon, sur la ligne 51 vers le coupleur du circuit 1 et vers les coupleurs des circuits 3 et 4. Au passage du point de raccordement de la ligne 51 au conducteur 5 du coupleur de chacun des autres circuits, l'échelon de tension décharge la capacité d'entrée de l'amplificateur 72 du coupleur du circuit considéré, vers la ligne 51. Arrivé en extrémité de ligne, l'échelon de tension provoque une circulation de courant dans l'impédance 56 qui correspond à l'échelon de courant car l'impédance 56 est adaptée à l'impédance caractéristique de la ligne.

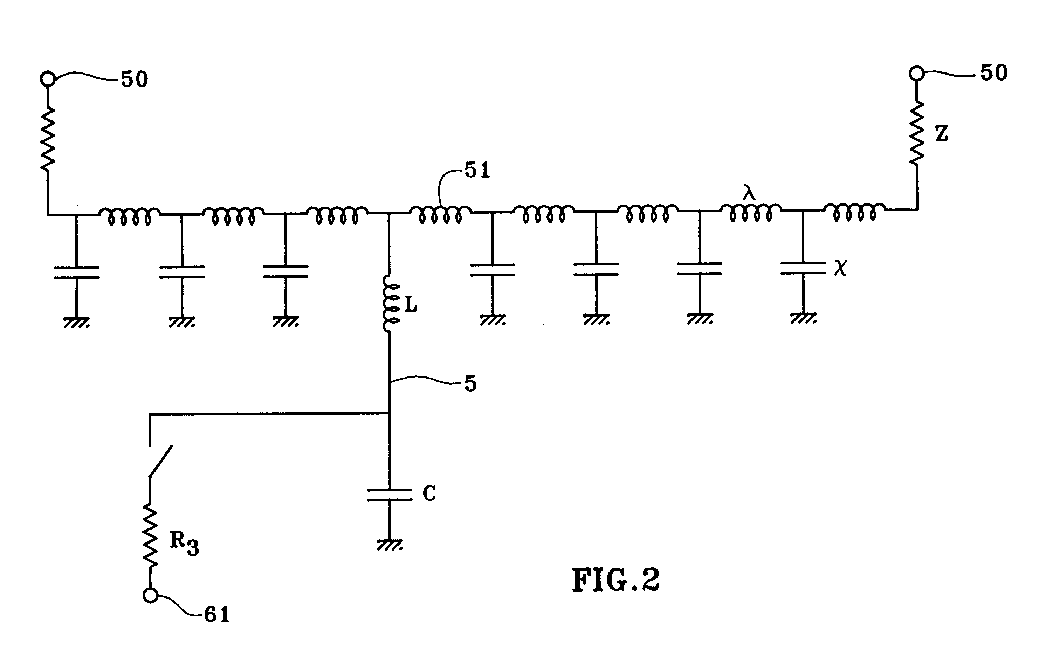

La figure 2 montre une représentation conceptuelle d'un circuit à haut débit d'échange d'information. La ligne 51 se comporte à haute fréquence comme une mise en série de dipôles infinitésimaux d'inductance linéique λ et de capacitance linéique χ, celles-ci définissent l'impédance caractéristique Z de la ligne. La connexion du conducteur 5 à la ligne 51 possède une inductance L. La connexion du conducteur 5 à l'amplificateur 72 possède une capacité C. L'interrupteur 63 est modélisé sous forme d'un interrupteur parfait et d'une résistance R3 qui n'est autre que la résistance de l'interrupteur 63 à l'état passant. La résistance R3 est de faible valeur; par exemple, avec Vn=0V, Vₜₜ=1,2V et R3=Z/10, on obtient Vb=0,2V. Considérant encore le coupleur du circuit 2 en mode émission, le potentiel du conducteur 5 étant à la valeur Vb, l'ouverture brutale de l'interrupteur 63 s'oppose à la circulation du courant établi dans le conducteur 5. Cependant, l'inductance de connexion L du conducteur 5 à la ligne 51 tend à maintenir ce courant qui vient alors charger la capacité d'entrée C de l'amplificateur 72. Le potentiel du conducteur 5 monte vers une valeur Vh propre à annuler le courant dans l'inductance de connexion. Cette valeur Vh ne dépend que de la capacité d'entrée C et de l'inductance de connexion L qui constituent les paramètres physiques du circuit. Suivant ces paramètres, la valeur Vh est inférieure, respectivement supérieure à la valeur Vtt, par exemple selon que la capacité d'entrée C est grande, respectivement négligeable devant l'inductance de connexion L. Comme il est difficile de maîtriser la valeur de ces paramètres, inhérente à la configuration matérielle du circuit, l'ouverture de l'interrupteur 63 a toutes les chances de transmettre sur la ligne 51, des valeurs transitoires de potentiel ne correspondant à aucun des deux états stables Vb ou Vtt. Ces valeurs transitoires retardent d'autant le moment où une évaluation correcte du signal transmis puisse être effectuée.

De plus, au niveau d'un coupleur hors mode émission, un échelon positif de tension sur la ligne 51 provoque une circulation de courant dans l'inductance de connexion L de ce coupleur pour charger la capacité d'entrée C de son amplificateur 72 à la nouvelle valeur de tension. Or l'inductance de connexion L crée un dépassement de la valeur de l'échelon de tension au niveau du coupleur récepteur, source de phénomènes transitoires supplémentaires sur la ligne 51. On voit alors apparaître sur la ligne 51 du circuit de la figure 1 une multitude d'ondes transitoires de tension dont la superposition en certains points est susceptible d'amener une interprétation contradictoire du signal à transmettre.

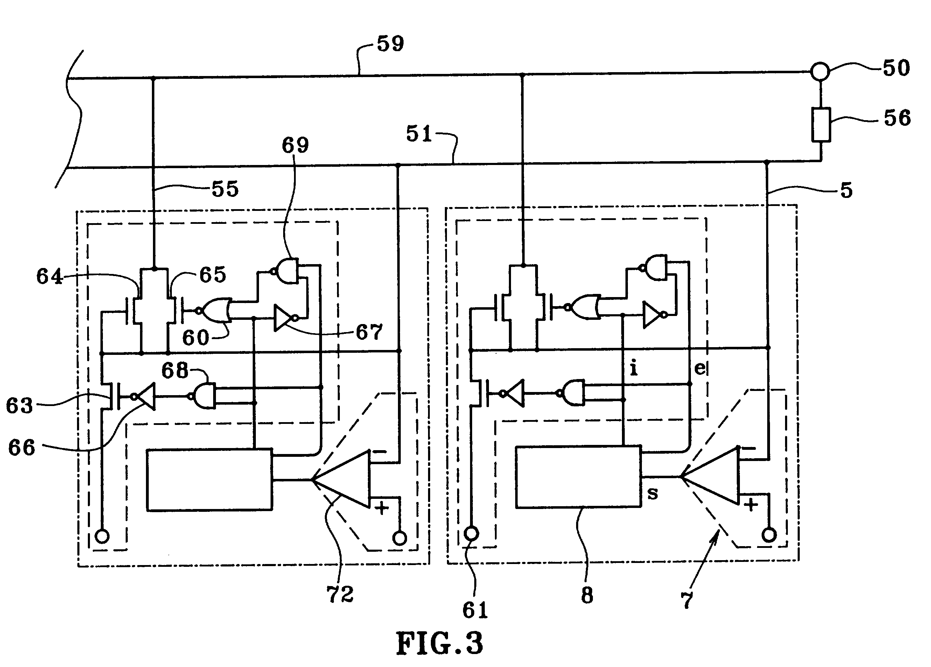

La figure 3 présente une vue partielle d'un circuit mettant en évidence différentes améliorations qui permettent d'éviter les inconvénients cités si dessus. Pour des raisons de clarté, seulement deux coupleurs raccordés à une même ligne 51 ont été représentés. La ligne 51 se prolonge implicitement vers la gauche où d'autres coupleurs sont éventuellement raccordés. De tels coupleurs sont attribués à différentes unités logiques 8 susceptibles de communiquer entre elles. Dans chaque coupleur, au moins un interrupteur 64, 65 est connecté entre le conducteur 5 et un conducteur 55. Ce conducteur 55 est connecté à un bus d'alimentation 59 qui constitue une source de potentiel Vtt par son raccordement au noeud 50. La figure 3 représente un exemple de réalisation de circuits en technologie CMOS. Ainsi l'interrupteur 64 est réalisé au moyen d'un transistor MOS dont le drain et la source sont respectivement reliés au conducteur 55 et au conducteur 5 et dont la grille est reliée au conducteur 5. L'interrupteur 65 est réalisé au moyen d'un transistor MOS à faible résistance dont le drain et la source sont respectivement reliés au conducteur 55 et au conducteur 5 et dont la grille est reliée à un bloc constitué d'éléments logiques 60,67,69.

L'interrupteur 64 est passant dès que et aussi longtemps que le potentiel du conducteur 5 dépasse le potentiel du conducteur 55 d'une tension de seuil. Dans l'exemple de réalisation de l'interrupteur 64 avec un transistor MOS, cette tension de seuil est de l'ordre de 0,6V. Or, l'interrupteur 63 possède une faible résistance à l'état passant. Dans l'état passant de l'interrupteur 63, le potentiel du conducteur 5 est donc à une valeur Vb, proche du potentiel Vn du noeud 61, nettement inférieure au potentiel du conducteur 55, proche quant à lui du potentiel Vtt du noeud 50. Ainsi, seul l'état bloquant de l'interrupteur 63 permet une valeur du potentiel du conducteur 5 supérieure à celle du potentiel du conducteur 55, et donc l'état passant de l'interrupteur 64. Ceci évite qu'une conduction simultanée de l'interrupteur 63 et de l'interrupteur 64, de part leur faible résistance, ne crée un court-circuit entre les potentiels Vtt et Vn et produise ainsi un échauffement rédhibitoire du circuit ou une pointe de courant perturbatrice. La faible valeur résistive ainsi possible des interrupteurs 63 et 64 permet de réduire le coefficient d'amortissement pour des variations rapides de potentiel du conducteur 5. Lorsque l'interrupteur 63 quitte l'état passant pour atteindre l'état bloquant, le courant maintenu par l'inductance de connexion L charge la capacité C, à l'entrée de l'amplificateur 72. Pour certaines valeurs de L/C par rapport à Z²/4, le potentiel du conducteur 5 dépasse le potentiel Vtt de la source de tension au delà de la tension de seuil. Cet événement place l'interrupteur 64 à l'état passant. Dans l'exemple de la figure 3, l'interrupteur 64 est réalisé au moyen d'un transistor MOS dont la grille et la source sont au potentiel du conducteur 5, et dont le drain est relié au conducteur 55 de potentiel Vtt. Un dépassement de la tension du conducteur 5 au dessus du potentiel Vtt, d'une valeur égale à la tension de seuil Vs du transistor provoque sa mise en conduction avec une résistance R4 qui diminue au fur et à mesure que le potentiel du conducteur 5 augmente. De la sorte, le potentiel du conducteur 5 est écrêté à une valeur Vtt+Vs+R4I4 où I4 est le courant traversant l'interrupteur 64. L'interrupteur 64 redevient bloquant lorsque le potentiel du conducteur 5 est inférieur à Vtt+Vs. On est sur ainsi que l'alternance suivante de potentiel du conducteur 5 ne descendra pas en dessous de Vtt-Vs. L'amplitude des oscillations, limitée à Vs est plus rapidement amortie par l'impédance caractéristique de la ligne à une valeur inférieure à (vtt-Vref). L'atteinte d'un potentiel compris entre Vref et Vtt par le conducteur 5 correspond ainsi rapidement à un état détecté stable. La mise en conduction rapide de l'interrupteur 64, à un niveau de conduction élevé, avec comme seule condition restrictive que l'interrupteur 63 soit bloquant, permet d'obtenir la combinaison de deux résultats à priori difficilement conciliables, un premier résultat de variations rapides possibles entre deux états discrets de potentiel Vb et Vtt du conducteur 5, un second résultat de grande stabilité sur chacun de ces deux états. Ces deux résultats, mis en évidence pour un fonctionnement du coupleur en mode émetteur, sont aussi avantageux pour son fonctionnement en mode récepteur. En effet, un dépassement intempestif de tension du conducteur 5 au delà de (Vtt+Vs) est écrêté à cette valeur.

La commande de l'état passant de l'interrupteur 63 est à tension de grille constante, par exemple 0,8V. Sa faible résistance est obtenue par une grande largeur du chemin drain-source. ll en résulte un encombrement de l'interrupteur 63 qui nécessite de la place dans le circuit intégré. Par contre, l'effet d'avalanche produit dans l'interrupteur 64 par le raccordement de la grille du transistor à sa source, amène une conduction élevée pour un encombrement nettement plus faible que celui du transistor 63.

La coordination des états passants et bloquants des interrupteurs 63 et 65 fonctionne de la façon suivante. Lorsque le signal e d'autorisation d'émission est à zéro, la sortie des portes 68 et 69 est à 1, il en résulte que la sortie des portes 60 et 66 est à zéro, entraînant ainsi l'état bloquant des interrupteurs 63 et 65. Le potentiel du conducteur 5 ne dépend que de celui de la ligne 51. Le signal e d'autorisation d'émission est défini de façon à ce qu'à chaque instant, il ne puisse être à 1 que pour au plus un coupleur parmi les coupleurs raccordés à une même ligne 51. Considérons un coupleur pour lequel le signal e d'autorisation d'émission passe à 1, les signaux e d'autorisation d'émission des autres coupleurs ont préalablement été mis à zéro suivant une logique de distribution des autorisations d'émission qui ne fait pas partie intégrante de l'invention. Le potentiel du conducteur 5 du coupleur considéré est normalement au potentiel Vtt distribué par la ligne 51. Un signal i d'émission ne peut être mis à 1 par l'unité logique 8 qu'après mise à 1 du signal e par cette même unité logique 8. Au passage à 1 du signal e, le signal i est encore à zéro. La sortie de la porte 67 est encore à 1 et la sortie de la porte 69 passe à zéro alors que la sortie de la porte 68 reste à 1. La sortie de la porte 60 passe à 1 alors que la sortie de la porte 66 reste à zéro. L'interrupteur 65 est rendu passant alors que l'interrupteur 63 reste bloquant. Le potentiel du conducteur 5 est maintenu au potentiel Vtt. Au passage à 1 du signal i, la sortie de la porte 60 passe à 0 avec un court retard Δt correspondant au temps de réponse de cette porte et la sortie de la porte 66 passe à 1 avec un court retard Δt' correspondant au temps de réponse de cette porte auquel s'ajoute un second retard Δt correspondant au temps de réponse de la porte 68. De cette manière, l'interrupteur 63 est rendu passant avec un retard Δt', correspondant au temps de réponse de la porte 66, après passage à l'état bloquant de l'interrupteur 65. L'état passant de l'interrupteur 63 tire le potentiel du conducteur 5 vers le potentiel Vn du noeud 61. La résistance R3 de l'interrupteur 63 est faible de façon à décharger rapidement la capacité C d'entrée de l'amplificateur 72. Le conducteur 5 est relié à l'extrémité opposée de l'interrupteur 63 à la ligne 51 qui se comporte comme une source de tension Vtt d'impédance interne Z/2, égale à l'impédance caractéristique de la ligne. Le potentiel du conducteur 5 se stabilise finalement à une valeur Vb dans le rapport (R3/(R3+Z/2)) de (Vtt-Vn) au dessus de Vn. Au passage à zéro du signal i, la sortie de la porte 66 passe à zéro avec le même retard Δt+Δt' qu'elle était passée de zéro à 1. Par contre, la porte 69 passe à zéro après un court retard Δt correspondant au temps de réponse de cette porte auquel vient s'ajouter un retard Δt' correspondant au temps de réponse de la porte 67. Ainsi, la porte 60 passe à 1 avec un retard Δt correspondant au temps de réponse de cette porte auquel s'ajoute le retard Δt+Δt'. De cette manière, l'interrupteur 65 est rendu passant avec un retard Δt, correspondant au temps de réponse de la porte 60, après passage à l'état bloquant de l'interrupteur 63. L'état passant de l'interrupteur 65 tire le potentiel du conducteur 5 vers le potentiel Vtt du bus 59.

Ainsi la porte 66 réalise une temporisation Δt' de la mise à l'état passant de l'interrupteur 63 sur la mise à l'état bloquant de l'interrupteur 65 et la porte 67 réalise une temporisation Δt de la mise à l'état passant de l'interrupteur 65 sur la mise à l'état bloquant de l'interrupteur 63. Des valeurs faibles des temporisations Δt' et Δt permettent des mises à l'état passant et bloquant rapides des interrupteurs 63 et 65, tout en assurant la non simultanéité de l'état passant des deux interrupteurs. L'absence de conduction simultanée de l'interrupteur 63 et de l'interrupteur 65, autorise de faibles valeurs de résistance tant pour les interrupteurs 63 et 65 que pour les conducteurs 5 et 55 sans risquer de créer un court-circuit entre les potentiels Vtt et Vn. On évite ainsi de produire un échauffement rédhibitoire du circuit ou une pointe de courant perturbatrice. De ces faibles valeurs de résistance, résulte un faible coefficient d'amortissement dans le conducteur 5 qui en permet des variations rapides de potentiel.

Toutefois, une valeur de résistance en conduction de l'interrupteur 65, de l'ordre de dix fois supérieure à celle de l'interrupteur 63 convient. En effet, l'énergie accumulée dans la ligne 51 ramène naturellement le potentiel du conducteur 5 vers la valeur Vtt lors du blocage de l'interrupteur 63. L'interrupteur 65 sert essentiellement à "accrocher" le potentiel du conducteur 5 à la valeur Vtt. Dans l'exemple particulier de la figure 3, les interrupteurs 63 et 65 sont réalisés au moyen de transistors MOS rendu passants par une tension de grille de l'ordre de 0,8V, fournie respectivement par les portes logiques 66 et 60. Dans ce mode de conduction, la résistance d'un transistor est inversement proportionnelle à la largeur de son chemin drain-source. Les dimensions de l'interrupteur 65 peuvent donc être nettement plus faibles que celles de l'interrupteur 63, ce qui réduit d'autant l'encombrement du coupleur dans le circuit intégré. Suivant les caractéristiques connues des transistors MOS, la résistance R5 de l'interrupteur 65 a tendance à augmenter avec la tension à ses bornes. Ceci a pour effet bénéfique d'amortir les oscillations qui écartent le potentiel du conducteur 5 de la valeur Vtt. Ainsi, le potentiel du conducteur 5 se stabilise rapidement à la valeur Vtt, imposée par le conducteur 55. La mise en conduction rapide de l'interrupteur 65, avec comme seule condition restrictive que l'interrupteur 63 soit bloquant, permet d'obtenir la combinaison de deux résultats à priori difficilement conciliables, un premier résultat de variations rapides possibles entre deux états discrets de potentiel Vb et Vtt du conducteur 5, un second résultat de grande stabilité sur chacun de ces deux états. L'utilisation de l'interrupteur 65 est particulièrement appropriée lorsque le potentiel du conducteur 5, après mise à l'état bloquant de l'interrupteur 63, atteint plus lentement le potentiel Vtt de la source de tension qu'en régime critique, ce qui correspond à des valeurs de UC faibles devant Z²/4.

La combinaison des deux résultats de variations rapides possibles entre deux états discrets de potentiel Vb et Vtt du conducteur 5, et de grande stabilité sur chacun de ces deux états présente un avantage utile à la transmission à distance de signaux à fréquence élevée. Ses signaux sont à deux états logiques E0 et E1 générés respectivement par la mise à l'état passant et la mise à l'état bloquant d'un interrupteur 63. Comme nous venons de le voir, ces résultats peuvent être obtenus par la mise en conduction rapide d'un interrupteur 64 ou 65, à un niveau de conduction élevé, avec comme seule condition restrictive que l'interrupteur 63 soit bloquant. La mise en conduction d'un interrupteur selon l'invention impose le potentiel Vtt du conducteur 5 alors que la mise en conduction de l'interrupteur 63 impose le potentiel Vb au conducteur 5.

Selon la valeur des paramètres physiques du circuit ( inductance, capacité ou impédance caractéristique ), l'utilisation du seul l'interrupteur 64 ou celle du seul interrupteur 65 est suffisante. Lorsque pour divers raisons telles que des dispersions de fabrication ou des dérives des conditions d'utilisation, on ne peut être certain de la valeur de ces paramètres, il est encore possible d'utiliser la combinaison des interrupteurs 64 et 65 mis en parallèle. Ainsi, suite à l'état bloquant de l'interrupteur 63, l'état passant de l'interrupteur 64 amorti les oscillations produites avant la mise à l'état passant de l'interrupteur 65. Ensuite, l'état passant de l'interrupteur 65 amorti les oscillations résiduelles.

Il est intéressant de noter que les interrupteurs 63 à 65 sont de type bloquants en l'absence de commande, par exemple réalisés exclusivement à l'aide de transistors NMOS. Ceci garantit qu'en l'absence de commande des interrupteurs, l'état du conducteur 5 d'un coupleur ne dépend que de l'état de son point de connexion à la ligne 51. Ce type d'interrupteurs réduit donc le risque de perturbation de la ligne 51 par un coupleur dont le circuit intégré l'incorporant aurait un défaut d'alimentation.

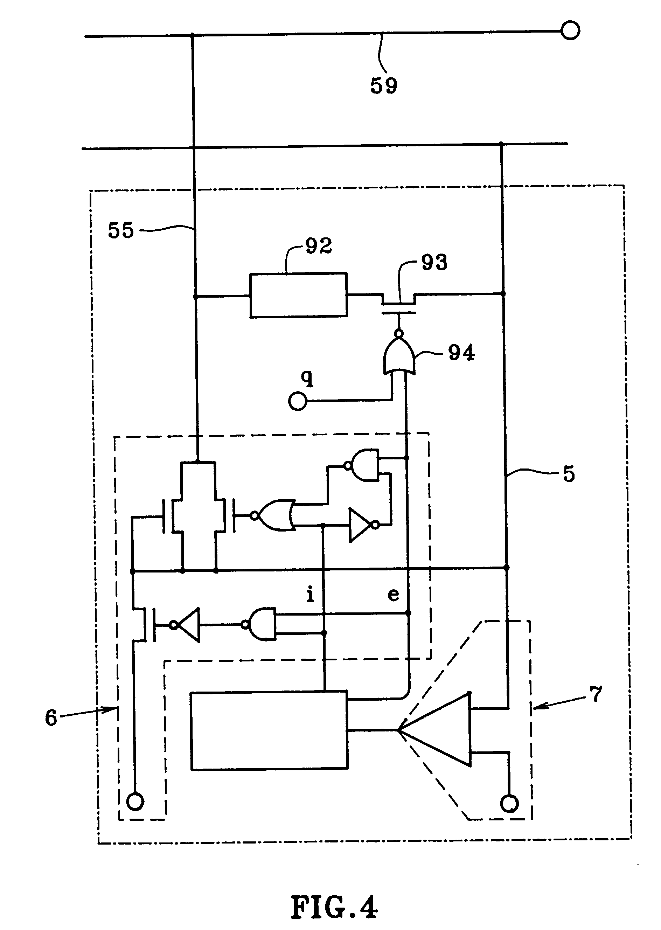

La figure 4 montre un interrupteur impédant, connecté entre le conducteur 5 et le conducteur 55. Cet interrupteur est par exemple constitué d'une impédance intégrée 92 et d'un transistor MOS 93 dont la grille est commandée par un élément logique 94. La valeur de l'impédance 92 est telle que l'impédance de l'interrupteur ainsi constitué soit adaptée à l'impédance caractéristique Z de la ligne pour un coupleur situé en extrémité de ligne. L'élément logique 94 est une porte NOR recevant en entrée le signal e d'autorisation d'émission et un signal binaire q à zéro lorsque le coupleur est situé en extrémité de ligne. L'état zéro du signal q peut être obtenu par exemple à l'aide d'un cavalier enfiché à l'extérieur du circuit intégré. Ainsi, pour un coupleur disposé en extrémité de ligne, lorsque le signal e d'autorisation d'émission est à zéro, le transistor MOS constitue un interrupteur passant qui connecte le conducteur 5 au potentiel du noeud 50 à travers le conducteur 55, le bus d'alimentation 59 et l'impédance 92. Un tel coupleur, hors mode émission, se comporte donc vis-à-vis de la ligne 51 comme l'impédance d'adaptation 56, telle qu'elle était mise en oeuvre sur les figures précédentes. Il n'est plus nécessaire de connecter les impédances d'adaptation sous forme de composants extérieurs aux circuits intégrés. Lorsque le signal e d'autorisation d'émission est à 1, le transistor MOS constitue un interrupteur bloquant entre le conducteur 5 et le conducteur 55. En mode émission, un coupleur situé en extrémité de ligne ne subit donc l'effet que de l'impédance d'adaptation située à l'autre extrémité de la ligne. Ainsi, au passage à l'état passant de l'interrupteur 63, l'onde courant-tension s'établissant dans le conducteur 5 est intégralement transmise sur la ligne 51 vers les autres coupleurs. Le front de cette onde n'est pas amorti par la présence d'une impédance d'adaptation. Pour un coupleur non disposé en extrémité de ligne, le signal q est à 1, le transistor 93 est bloquant. Le front de l'onde courant-tension se réparti en deux valeurs égales vers chaque extrémité de la ligne 51.

## Revendications

1. Coupleur d'entrée sortie d'un circuit intégré, pour échanger des signaux avec au moins deux coupleurs identiques d'autres circuits intégrés par une ligne de bus (51), comprenant un émetteur (6) et un récepteur (7) raccordés à la ligne (51) par un conducteur (5), l'émetteur (6) comprenant un interrupteur (63) dont l'état passant met le conducteur (5) à un potentiel Vb, caractérisé en ce qu'il comprend au moins un interrupteur (64),(65) dont l'état passant amène le conducteur (5) à un potentiel Vtt et tel que la mise à l'état passant de l'interrupteur (64),(65) n'est possible qu'après mise à l'état bloquant de l'interrupteur (63).

2. Coupleur d'entrée sortie suivant la revendication 1, caractérisé en ce que le franchissement, par le potentiel du conducteur (5), d'un seuil au delà du potentiel Vtt met immédiatement l'interrupteur (64) à l'état passant.

3. Coupleur d'entrée sortie suivant la revendication 1, caractérisé en ce que la commande à l'état passant de l'interrupteur (65) est verrouillée par la commande à l'état passant de l'interrupteur (63) et déverrouillée avec une temporisation infinitésimale sur la mise à l'état bloquant de l'interrupteur (63).

4. Coupleur d'entrée sortie suivant la revendication 3, caractérisé en ce que la commande à l'état passant de l'interrupteur (63) est verrouillée par la commande à l'état passant de l'interrupteur (65) et déverrouillée avec une temporisation infinitésimale sur la mise à l'état bloquant de l'interrupteur (65).

5. Coupleur d'entrée sortie suivant la revendication 3, caractérisé en ce que la temporisation infinitésimale sur la mise à l'état bloquant de l'interrupteur (63) est réalisée par une porte logique (67).

6. Coupleur d'entrée sortie suivant la revendication 4, caractérisé en ce que la temporisation infinitésimale sur la mise à l'état bloquant de l'interrupteur (65) est réalisée par une porte logique (66).

7. Coupleur d'entrée sortie suivant la revendication 1, caractérisé en ce qu'il comprend un interrupteur impédant (92,93), connecté entre le conducteur (5) et un conducteur (55) au potentiel Vtt, dont l'impédance est égale à l'impédance caractéristique de la ligne (51), cet interrupteur étant passant lorsque le coupleur est situé à l'une des extrémités de la ligne (51) hors mode émission.

8. Coupleur d'entrée sortie suivant la revendication 2, caractérisé en ce que, dans l'état passant de l'interrupteur (64), sa conductivité électrique croit avec le potentiel du conducteur (5).

9. Coupleur d'entrée sortie suivant la revendication 2 ou 8, caractérisé en ce que l'interrupteur (64) est réalisé au moyen d'un transistor MOS dont le drain est connecté à un conducteur (55) de potentiel Vtt et dont la grille et la source sont connectées au conducteur (5).

10. Coupleur d'entrée sortie suivant la revendication 7, caractérisé en ce que l'interrupteur (92,93) est réalisé au moyen de transistors MOS.
